# EUROPEAN PATENT APPLICATION

(11) **EP 2 063 318 A1**
(43) Date of publication of application: **27.05.2009**
(21) Application number: 07807001.8
(22) Date of filing: 10.09.2007
(51) Int. Cl.: G03F 7/027, C08F 299/02, G03F 7/004, H05K 3/00, H05K 3/06, H05K 3/18

(54) **PHOTOSENSITIVE RESIN COMPOSITION, PHOTOSENSITIVE ELEMENT, METHOD FOR FORMING RESIST PATTERN, AND METHOD FOR PRODUCING PRINTED WIRING BOARD**

(30) Priority: 13.09.2006 JP 2006247966; 22.06.2007 JP 2007165303
(71) Applicant: Hitachi Chemical Company, Ltd., Tokyo 163-0449 (JP)
(72) Inventor: AJIOKA, Yoshiki, Hitachi-shi, Ibaraki 317-8555 (JP); KOYANAGI, Kouji, Hitachi-shi, Ibaraki 317-8555 (JP); WATANABE, Mitsuaki, Hitachi-shi, Ibaraki 317-8555 (JP)
(74) Representative: Albrecht, Thomas
(86) International application number: PCT/JP2007/067591
(87) International publication number: WO 2008/032674

(57) **Abstract**

A photosensitive resin composition comprising (A) a binder polymer, (B) a photopolymerizing compound with an ethylenic unsaturated bond, and (C) a photopolymerization initiator, wherein component (B) includes a photopolymerizing compound with an organic group represented by the following general formula (1). 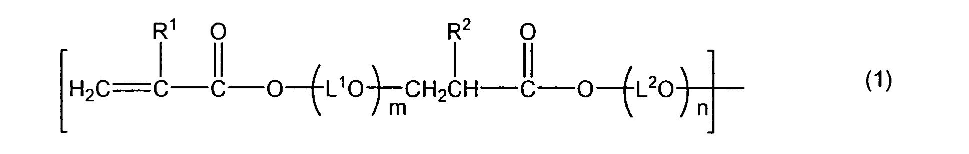 In the formula, R¹ and R² each independently represent hydrogen or a methyl group, L¹ and L² each independently represent a C1-6 alkylene group and m and n each independently represent an integer of 0-50 selected so that the total of m and n is 0-50.

## Description

### Technical Field

The present invention relates to a photosensitive resin composition, a photosensitive element, a resist pattern forming method and a process for production of a printed wiring board.

### Background Art

In the field of printed wiring board manufacturing, photosensitive resin compositions, and photosensitive elements obtained by forming photosensitive resin composition layers composed of photosensitive resin compositions onto support films and covering the photosensitive resin composition layers with protective films are commonly known as resist materials for etching or plating.

When such a photosensitive element is used, the printed wiring board may be fabricated, for example, in the following manner. First, the photosensitive resin composition layer of the photosensitive element is laminated onto a circuit-forming board. The side of the photosensitive resin composition layer opposite the side in contact with the support film is contact bonded to the side of the circuit-forming board on which the circuit is to be formed. The procedure is carried out while releasing the protective film. Next, exposure is performed through a mask film or the like to form an image (pattern), and then the unexposed sections are removed with a developing solution to form a resist pattern. The resist pattern is in turn used as a mask for etching or plating, in order to form a circuit pattern, and finally the cured sections are released and removed from the base.

In this type of printed wiring board production process, the developing solution used to remove the unexposed sections of the photosensitive element may be, for most purposes, any one capable of dissolving or dispersing the photosensitive resin composition layer to some extent. In consideration of environmental friendliness and safety, alkali developer using an aqueous sodium carbonate or sodium hydrogencarbonate solution is currently most commonly employed. However, a demand exists for photosensitive resin compositions that exhibit excellent tenting properties that are not impaired by the spray pressure of the developing solution or rinsing after exposure, or in other words, excellent "tent reliability". As photosensitive resin compositions with excellent tent reliability, there have been proposed photosensitive resin compositions comprising difunctional or trifunctional monomers (for example, see Patent documents 1-5).
[Patent document 1] International Patent Publication No. WO01/092958
[Patent document 2] Japanese Patent Application Laid-Open No. 2000-214583
[Patent document 3] Japanese Patent No. 3251446
[Patent document 4] Japanese Patent Application Laid-Open No. 2005-31639
[Patent document 5] Japanese Patent No. 3199600

### Disclosure of the Invention

### Problems to be Solved by the Invention

With photosensitive resin compositions comprising bifunctional monomers, however, the tent reliability is not always satisfactory, and with photosensitive resin compositions comprising trifunctional monomers, the obtained cured films tend to be hard and brittle.

The present invention has been completed in light of the circumstances described above, and its object is to provide a photosensitive resin composition with satisfactorily excellent tent reliability allowing formation of cured films with sufficient mechanical strength and flexibility, as well as a photosensitive element, resist pattern forming method and printed wiring board production process employing the same.

### Means for Solving the Problems

The invention provides a photosensitive resin composition comprising (A) a binder polymer, (B) a photopolymerizing compound with an ethylenic unsaturated bond, and (C) a photopolymerization initiator, wherein component (B) includes a photopolymerizing compound with an organic group represented by the following general formula (1).

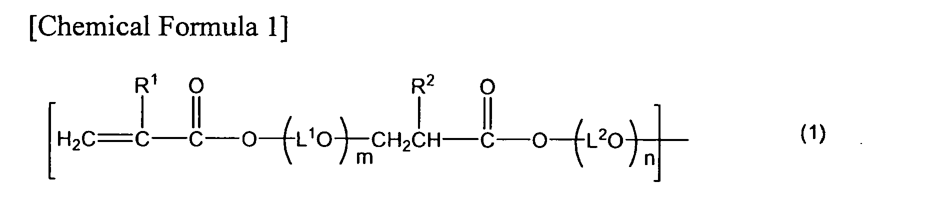

In the formula, R¹ and R² each independently represent hydrogen or a methyl group, L¹ and L² each independently represent a C1-6 alkylene group and m and n each independently represent an integer of 0-50 selected so that the total of m and n is 0-50.

The photosensitive resin composition of the invention comprises components (A), (B) and (C) as essential components, and by including a photopolymerizing compound with an organic group represented by general formula (1) as component (B), it is possible to form a cured film with sufficient mechanical strength and flexibility while achieving excellent tent reliability. Although the reason for the resulting effect is not entirely understood, the present inventors conjecture that the presence of the organic group represented by general formula (1) above is a contributing factor. However, this is not necessarily the only reason.

The photopolymerizing compound with an organic group represented by general formula (1) is preferably a photopolymerizing compound represented by the following general formula (2).

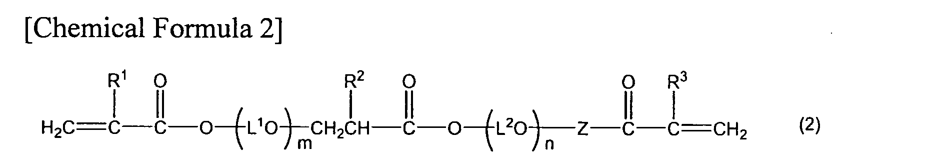

In the formula, R¹, R² and R³ each independently represent hydrogen or a methyl group, L¹ and L² each independently represent a C1-6 alkylene group, Z represents a single bond or a divalent organic group and m and n each independently represent an integer of 0-50 selected so that the total of m and n is 0-50.

This type of photosensitive resin composition can form cured films with more excellent mechanical strength and flexibility, and can also further enhance the tent reliability.

In general formula (2), Z is preferably a divalent organic group represented by the following general formula (3) or (4). 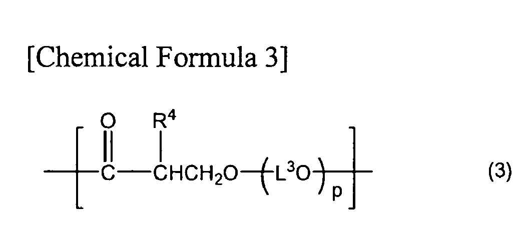 In this formula, R⁴ represents hydrogen or a methyl group, L³ represents a C1-6 alkylene group and p represents an integer of 0-25. 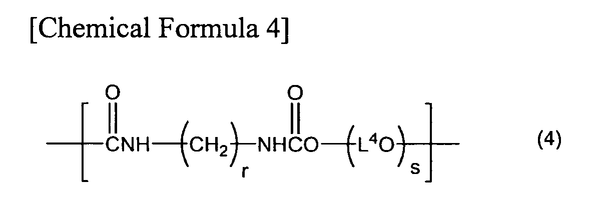 In this formula, L⁴ represents a C1-6 alkylene group, r represents an integer of 1-25 and s represents an integer of 0-25.

This will permit the effect of the invention to be even more effectively exhibited for more excellent tent reliability.

The invention also provides a photosensitive element comprising a support film and a photosensitive resin composition layer made of the aforementioned photosensitive resin composition formed on the support film.

Since this type of photosensitive element comprises a photosensitive resin composition layer composed of the photosensitive resin composition of the invention, it can exhibit the satisfactory mechanical strength and flexibility of a cured film composed of the photosensitive resin composition layer, while also exhibiting satisfactorily excellent tent reliability.

The invention additionally provides a resist pattern forming method wherein a photosensitive resin composition layer comprising the aforementioned a photosensitive element is laminated on a circuit-forming board, the photosensitive resin composition layer is irradiated with active light rays in an image pattern for photocuring of the exposed sections, and the sections other than the exposed sections are removed.

According to the resist pattern forming method of the invention, it is possible to form high density resist patterns on circuit-forming boards with high productivity.

The present invention further provides a process for production of a printed wiring board comprising a step of etching or plating a circuit-forming board having a resist pattern formed by the aforementioned resist pattern forming method, to form a circuit pattern.

The process for production of a printed wiring board according to the invention allows formation of satisfactory resist patterns on circuit-forming boards by the resist pattern forming method described above, so that highly densified printed wiring boards can be produced with high efficiency.

### Effect of the Invention

According to the invention it is possible to provide a photosensitive resin composition that allows formation of cured films with sufficient mechanical strength and flexibility and that has satisfactorily excellent tent reliability, as well as a photosensitive element, a resist pattern forming method and a printed wiring board production process employing the same.

### Brief Description of the Drawings

Fig. 1 is a schematic cross-sectional view showing a preferred embodiment of a photosensitive element of the invention.
Fig. 2 is a plan view of a hole tear counting board used for evaluation of the irregular tent tear rate.

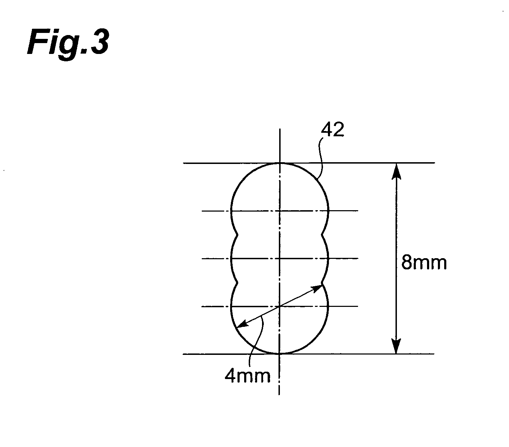

Fig. 3 is a magnified view of three continuous holes in region A of Fig. 2.

### Explanation of Symbols

1: Photosensitive element, 10: support, 20: photosensitive resin composition layer, 30: protective film, 40: hole tear counting board, 41: round hole, 42: three continuous holes, 43: copper clad laminate.

### Best Modes for Carrying Out the Invention

Preferred embodiments of the invention will now be explained in detail, with reference to the accompanying drawings as necessary. Identical elements in the drawings will be referred to by like reference numerals and will be explained only once. The vertical and horizontal positional relationships are based on the positional relationships in the drawings, unless otherwise specified. Also, the dimensional proportions depicted in the drawings are not necessarily limitative. The term "(meth)acrylate" used throughout the present specification refers to the "acrylate" and its corresponding "methacrylate". Similarly, the term "(meth)acrylic" refers to the "acrylic" and its corresponding "methacrylic" compound, and "(meth)acryloyl" refers to the "acryloyl" and its corresponding "methacryloyl" compound.

### (Photosensitive resin composition)

The photosensitive resin composition of the invention comprises (A) a binder polymer (hereinafter referred to as "component (A)"), (B) a photopolymerizing compound with an ethylenic unsaturated bond (hereinafter referred to as "component (B)") and (C) a photopolymerization initiator (hereinafter referred to as "component (C)"), and contains a photopolymerizing compound with an organic group represented by general formula (1) as component (B).

Component (A), component (B) and component (C) will now be explained in further detail.

As examples for the binder polymer as component (A) there may be mentioned acrylic resins, styrene resins, epoxy resins, amide resins, amide-epoxy resins, alkyd resins and phenol resins. An acrylic resin is preferably used from the viewpoint of obtaining an excellent alkali developing property. Any of these may be used alone or in combinations of two or more.

The (A) binder polymer may be produced, for example, by radical polymerization of a polymerizable monomer. As examples of such polymerizable monomers there may be mentioned polymerizable styrene derivatives substituted at the α-position or on the aromatic ring with styrene, vinyltoluene, α-methylstyrene or the like, acrylamides such as diacetoneacrylamide, acrylonitrile, vinyl alcohol esters such as vinyl-n-butyl ether, (meth)acrylic acid alkyl ester, (meth)acrylic acid tetrahydrofurfuryl ester, (meth)acrylic acid dimethylaminoethyl ester, (meth)acrylic acid diethylaminoethyl ester, (meth)acrylic acid glycidyl ester, 2,2,2-trifluoroethyl (meth)acrylate, 2,2,3,3-tetrafluoropropyl (meth)acrylate, (meth)acrylic acid, α-bromo(meth)acrylic acid, α-chlor(meth)acrylic acid, β-furyl(meth)acrylic acid, β-styryl(meth)acrylic acid, maleic acid, maleic acid monoesters such as maleic acid anhydride, monomethyl malate, monoethyl malate and monoisopropyl malate, fumaric acid, cinnamic acid, α-cyanocinnamic acid, itaconic acid, crotonic acid, propiolic acid and the like.

As examples of (meth)acrylic acid alkyl esters there may be mentioned compounds represented by the following general formula (5), and the same compounds with the alkyl groups substituted with hydroxyl groups, epoxy groups, halogen atoms or the like.

CH₂=C(R⁶)-COOR⁷ (5)

In this formula, R⁶ represents hydrogen or a methyl group, and R⁷ represents a C1-12 alkyl group. As examples of C1-12 alkyl groups there may be mentioned methyl, ethyl, propyl, butyl, pentyl, hexyl, heptyl, octyl, nonyl, decyl, undecyl, dodecyl and their structural isomers.

As examples of compounds represented by general formula (5) above there may be mentioned (meth)acrylic acid methyl ester, (meth)acrylic acid ethyl ester, (meth)acrylic acid propyl ester, (meth)acrylic acid butyl ester, (meth)acrylic acid pentyl ester, (meth)acrylic acid hexyl ester, (meth)acrylic acid heptyl ester, (meth)acrylic acid octyl ester, (meth)acrylic acid 2-ethylhexyl ester, (meth)acrylic acid nonyl ester, (meth)acrylic acid decyl ester, (meth)acrylic acid undecyl ester and (meth)acrylic acid dodecyl ester. Any of these may be used alone or in combinations of two or more.

The (A) binder polymer to be used for the invention preferably has a carboxyl group from the viewpoint of obtaining a more satisfactory alkali developing property. Such a binder polymer (A) may be obtained, for example, by radical polymerization of a carboxyl group-containing polymerizable monomer with another polymerizable monomer. (Meth)acrylic acid mentioned above is preferred as a carboxyl group-containing polymerizable monomer.

The proportion of carboxyl groups in the binder polymer, as the fraction of polymerizable monomers with carboxyl groups with respect to the total polymerizable monomers used is preferably 12-50 wt%, more preferably 12-40 wt%, even more preferably 15-30 wt% and most preferably 15-25 wt%, from the viewpoint of achieving a satisfactory balance between alkali developing property and alkali resistance. A carboxyl group-containing polymerizable monomer content of less than 12 wt% will tend to result in an inferior alkali developing property, while a content of greater than 50 wt% will tend to lower the alkali resistance.

From the viewpoint of further improving the flexibility, the binder polymer also preferably includes styrene or a styrene derivative as a polymerizable monomer. Using styrene or a styrene derivative as a polymerizable monomer will result in good adhesiveness and a satisfactory release property of the photosensitive resin composition.

From the viewpoint of more reliably improving the adhesiveness and release property of the photosensitive resin composition, the content of the styrene or styrene derivative is preferably 0.1-30 wt%, more preferably 1-28 wt% and even more preferably 1.5-27 wt% based on the total weight of the polymerizable monomers in the binder polymer. If the content is less than 0.1 wt% the adhesiveness will tend to be reduced, and if it is greater than 30 wt% the release strip will be larger, tending to lengthen the release time.

The term "styrene derivative" according to the invention means styrene wherein a hydrogen has been substituted with a substituent (an organic group such as alkyl, or a halogen atom or the like).

From the viewpoint of a satisfactory balance between the mechanical strength and alkali developing property, the weight-average molecular weight of the binder polymer is preferably 20,000-300,000, more preferably 40,000-150,000 and most preferably 50,000-100,000. A weight-average molecular weight of less than 20,000 will tend to result in lower developing solution resistance, and greater than 300,000 will tend to lengthen the developing time. The weight-average molecular weight for the purpose of the invention is the value measured by gel permeation chromatography (GPC) and calculated using a calibration curve prepared using standard polystyrene.

Such binder polymers are used alone or in combinations of two or more. As examples of binder polymers when two or more are used in combination, there may be mentioned two or more binder polymers composed of different copolymerizing components, two or more binder polymers with different weight-average molecular weights, and two or more binder polymers with different dispersibilities.

Component (B) will now be explained. Component (B) according to the invention is a photopolymerizing compound with an ethylenic unsaturated group, and it contains a photopolymerizing compound with an organic group represented by the following general formula (1).

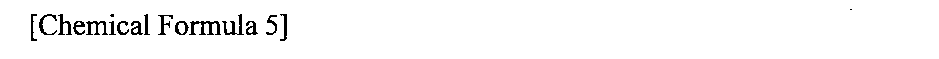

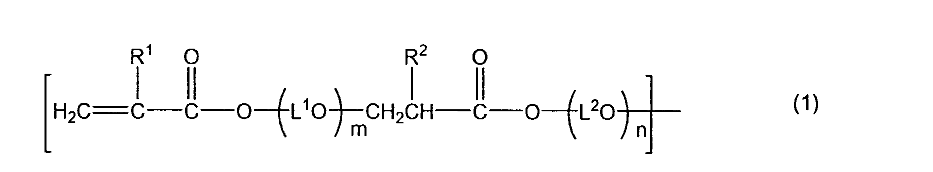

In general formula (1), R¹ and R² each independently represent hydrogen or a methyl group, L¹ and L² each independently represent a C1-6 alkylene group and m and n each independently represent an integer of 0-50 selected so that the total of m and n is 0-50.

The photosensitive resin composition of the invention, which contains a photopolymerizing compound with an organic group represented by general formula (1) above as component (B), can form cured films with sufficient mechanical strength and flexibility, not only satisfactorily improving the tent reliability but also providing excellent hydrophilicity and developing solution resistance.

From the viewpoint of further improving the hydrophilicity, developing solution resistance and cured film mechanical strength, the photopolymerizing compound with an organic group represented by general formula (1) above is preferably a compound represented by the following general formula (2).

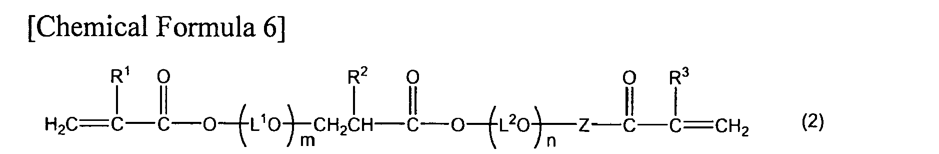

In general formula (2), R¹, R² and R³ each independently represent hydrogen or a methyl group, L¹ and L² each independently represent a C1-6 alkylene group, Z represents a single bond or a divalent organic group and m and n each independently represent an integer of 0-50 selected so that the total of m and n is 0-50.

The C1-6 alkylene group in L¹ and L² of general formulas (1) and (2) may be, for example, a methylene, ethylene, propylene, isopropylene, butylene, isobutylene, pentylene, neopentylene or hexylene group, but is preferably an ethylene group. When L¹ and/or L² is an isopropylene group [-CH(CH₃)CH₂-] and multiple -(L¹-O)-and/or -(L²-O)- divalent groups are present, the coupling direction of the isopropylene groups is different depending on whether the methylene group is bonded or not bonded to the oxygen in the divalent group. The coupling directions of the isoprene groups may both be the same coupling direction, or a combination of the two different coupling directions.

When m and/or n is 2 or greater, the two or more L¹ and/or L² groups may be the same or different. Also, when L¹ and/or L² is composed of 2 or more different alkylene groups, the bonding form of the two or more different -(L¹-O)ₘ- and/or -(L²-O)ₙ- groups may be, independently, random copolymerization or block copolymerization. Also, m and n are each independently such that the total of m and n is 0-50, but from the viewpoint of hydrophilicity and developing solution resistance, the total of m and n is preferably 1-40, more preferably 10-40 and most preferably 15-35.

In addition, Z is preferably a divalent organic group represented by the following general formula (3) or general formula (4).

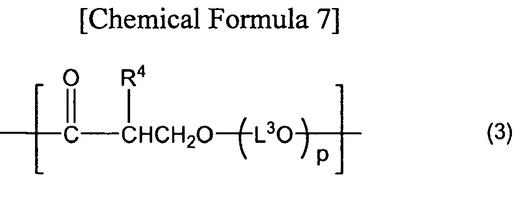

In general formula (3), R⁴ represents hydrogen or a methyl group, and L³ represents a C1-6 alkylene group. Also, p represents an integer of 0-25, but from the viewpoint of hydrophilicity and developing solution resistance, it is preferably an integer of 1-20 and more preferably an integer of 5-15.

The C1-6 alkylene group in L³ may be, for example, a methylene, ethylene, propylene, isopropylene, butylene, isobutylene, pentylene, neopentylene or hexylene group, but is preferably an ethylene group. When L³ is an isopropylene group and multiple -(L³-O)- divalent groups are present, the coupling direction of the isopropylene groups is different depending on whether the methylene group is bonded or not bonded to the oxygen in the divalent group. The coupling directions of the isoprene groups may be the same coupling direction, or a combination of the two different coupling directions. When p is 2 or greater, the two or more L³ groups may be the same or different. Also, when L³ is composed of 2 or more different alkylene groups, the bonding form of the two or more different -(L³-O)ₚ- groups may be, independently, random copolymerization or block copolymerization.

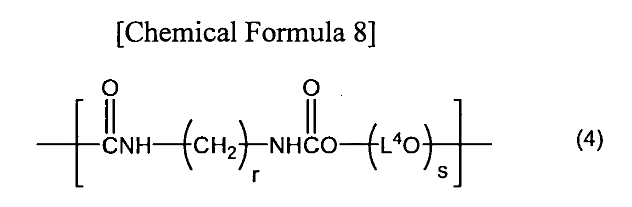

In general formula (4), L⁴ represents a C1-6 alkylene group. Also, r represents an integer of 1-25. From the viewpoint of further improving the hydrophilicity and developing solution resistance and the mechanical strength and flexibility of the obtained cured film, r is preferably an integer of 2-10 and more preferably an integer of 4-8. Also, s represents an integer of 0-25. From the viewpoint of further improving the hydrophilicity and developing solution resistance, s is preferably an integer of 1-20 and more preferably an integer of 5-15.

The C1-6 alkylene group in L⁴ may be, for example, a methylene, ethylene, propylene, isopropylene, butylene, isobutylene, pentylene, neopentylene or hexylene group, but is preferably an ethylene group. When L⁴ is an isopropylene group and multiple -(L⁴-O)- divalent groups are present, the coupling direction of the isopropylene groups is different depending on whether the methylene group is bonded or not bonded to the oxygen in the divalent group. The coupling directions of the isoprene groups may be a single coupling direction, or a combination of the two different coupling directions. When s is 2 or greater, the two or more L⁴ groups may be the same or different. Also, when L⁴ is composed of 2 or more different alkylene groups, the bonding form of the two or more different -(L⁴-O)ₛ- groups may be, independently, random copolymerization or block copolymerization.

The photopolymerizing compound with an organic group represented by general formula (1) above may be produced, for example, by 1,4-addition reaction of a (meth)acryloyl group-containing compound onto a compound with an α,β-unsaturated carbonyl group. As compounds with α,β-unsaturated carbonyl groups there may be mentioned α,β-unsaturated ketones, α,β-unsaturated esters and α,β-unsaturated amides. As examples of (meth)acryloyl group-containing compounds there may be mentioned compounds represented by R-H, R-X, R-OH, R-SH, R-M, R-O-M and R-S-M. In these formulas, R represents an organic group with a (meth)acryloyl group, X represents a halogen atom and M represents a metal atom, and two or more metal salts or a salt of a metal and a non-metal may be used.

As component (B) there may also be included another photopolymerizing compound with an ethylenic unsaturated bond in addition to the photopolymerizing compound with an organic group represented by general formula (1) above. As examples of other photopolymerizing compounds with ethylenic unsaturated bonds there may be mentioned compounds obtained by reacting polyhydric alcohols with α,β-unsaturated carboxylic acids, bisphenol A-based (meth)acrylate compounds such as 2,2-bis(4-((meth)acryloxypolyethoxy)phenyl)propanes, 2,2-bis(4-((meth)acryloxypolypropoxy)phenyl)propanes and 2,2-bis(4-((meth)acryloxypolyethoxypolypropoxy)phenyl)propanes, compounds obtained by reacting glycidyl group-containing compounds with α,β-unsaturated carboxylic acids, urethane monomers such as urethane bond-containing (meth)acrylate compounds, γ-chloro-β-hydroxypropyl-β'-(meth)acryloyloxyethyl-o-phthalate, β-hydroxyethyl-β'-(meth)acryloyloxyethyl-o-phthalate, β-hydroxypropyl-β'-(meth)acryloyloxyethyl-o-phthalate, (meth)acrylic acid alkyl esters and the like. From the viewpoint of improving the adhesiveness, component (B) preferably includes a bisphenol A-based (meth)acrylate compound or urethane bond-containing (meth)acrylate compound. From the viewpoint of improving the sensitivity and resolution, it preferably includes a bisphenol A-based (meth)acrylate compound. These may be used alone or in combinations of two or more.

As examples of 2,2-bis(4-((meth)acryloxypolyethoxy)phenyl)propanes there may be mentioned 2,2-bis(4-((meth)acryloxydiethoxy)phenyl)propane, 2,2-bis(4-((meth)acryloxytriethoxy)phenyl)propane, 2,2-bis(4-((meth)acryloxytetraethoxy)phenyl)propane, 2,2-bis(4-((meth)acryloxypentaethoxy)phenyl)propane, 2,2-bis(4-((meth)acryloxyhexaethoxy)phenyl)propane, 2,2-bis(4-((meth)acryloxyheptaethoxy)phenyl)propane, 2,2-bis(4-((meth)acryloxyoctaethoxy)phenyl)propane, 2,2-bis(4-((meth)acryloxynonaethoxy)phenyl)propane, 2,2-bis(4-((meth)acryloxydecaethoxy)phenyl)propane, 2,2-bis(4-((meth)acryloxyundecaethoxy)phenyl)propane, 2,2-bis(4-((meth)acryloxydodecaethoxy)phenyl)propane, 2,2-bis(4-((meth)acryloxytridecaethoxy)phenyl)propane, 2,2-bis(4-((meth)acryloxytetradecaethoxy)phenyl)propane, 2,2-bis(4-((meth)acryloxypentadecaethoxy)phenyl)propane and 2,2-bis(4-((meth)acryloxyhexadecaethoxy)phenyl)propane. Among these, 2,2-bis(4-(methacryloxypentaethoxy)phenyl)propane is commercially available as "BPE-5.00" (trade name of Shin-Nakamura Chemical Co., Ltd.), and 2,2-bis(4-(methacryloxypentadecaethoxy)phenyl)propane is commercially available as "BPE-1300" (trade name of Shin-Nakamura Chemical Co., Ltd.). These may be used alone or in combinations of two or more.

As examples of 2,2-bis(4-((meth)acryloxypolypropoxy)phenyl)propanes there may be mentioned 2,2-bis(4-((meth)acryloxydipropoxy)phenyl)propane, 2,2-bis(4-((meth)acryloxytripropoxy)phenyl)propane, 2,2-bis(4-((meth)acryloxytetrapropoxy)phenyl)propane, 2,2-bis(4-((meth)acryloxypentapropoxy)phenyl)propane, 2,2-bis(4-((meth)acryloxyhexapropoxy)phenyl)propane, 2,2-bis(4-((meth)acryloxyheptapropoxy)phenyl)propane, 2,2-bis(4-((meth)acryloxyoctapropoxy)phenyl)propane, 2,2-bis(4-((meth)acryloxynonapropoxy)phenyl)propane, 2,2-bis(4-((meth)acryloxydecapropoxy)phenyl)propane, 2,2-bis(4-((meth)acryloxyundecapropoxy)phenyl)propane, 2,2-bis(4-((meth)acryloxydodecapropoxy)phenyl)propane, 2,2-bis(4-((meth)acryloxytridecapropoxy)phenyl)propane, 2,2-bis(4-((meth)acryloxytetradecapropoxy)phenyl)propane, 2,2-bis(4-((meth)acryloxypentadecapropoxy)phenyl)propane and 2,2-bis(4-((meth)acryloxyhexadecapropoxy)phenyl)propane. These may be used alone or in combinations of two or more.

As examples of 2,2-bis(4-((meth)acryloxypolyethoxypolypropoxy)phenyl)propanes there may be mentioned 2,2-bis(4-((meth)acryloxydiethoxyoctapropoxy)phenyl)propane, 2,2-bis(4-((meth)acryloxytetraethoxytetrapropoxy)phenyl)propane, 2,2-bis(4-((meth)acryloxyhexaethoxyhexapropoxy)phenyl)propane and the like. These may be used alone or in combinations of two or more.

As examples of compounds obtained by reacting polyhydric alcohols with α,β-unsaturated carboxylic acids there may be mentioned polyethyleneglycol di(meth)acrylates with 2-14 ethylene groups, polypropyleneglycol di(meth)acrylates with 2-14 propylene groups, polyethylenepolypropyleneglycol di(meth)acrylates with 2-14 ethylene groups and 2-14 propylene groups, trimethylolpropane di(meth)acrylate, trimethylolpropane tri(meth)acrylate, trimethylolpropaneethoxy tri(meth)acrylate, trimethylolpropanediethoxy tri(meth)acrylate, trimethylolpropanetriethoxy tri(meth)acrylate, trimethylolpropanetetraethoxy tri(meth)acrylate, trimethylolpropanepentaethoxy tri(meth)acrylate, tetramethylolmethane tri(meth)acrylate, tetramethylolmethane tetra(meth)acrylate, polypropyleneglycol di(meth)acrylates with 2-14 propylene groups, dipentaerythritol penta(meth)acrylate, dipentaerythritol hexa(meth)acrylate and the like.

As examples of urethane monomers there may be mentioned addition reaction products of (meth)acrylic monomers with a hydroxyl group at the β position and diisocyanate compounds such as isophorone diisocyanate, 2,6-toluene diisocyanate, 2,4-toluene diisocyanate and 1,6-hexamethylene diisocyanate, as well as tris[(meth)acryloxytetraethyleneglycol isocyanate]hexamethylene isocyanurate, EO-modified urethane di(meth)acrylate and EO,PO-modified urethane di(meth)acrylate. "EO" stands for ethylene oxide, and an EO-modified compound has a block structure of ethylene oxide groups. "PO" stands for propylene oxide, and a PO-modified compound has a block structure of propylene oxide groups. As an example of an EO-modified urethane di(meth)acrylate compound there may be mentioned "UA-11" (trade name of Shin-Nakamura Chemical Co., Ltd.). As an example of an EO,PO-modified urethane di(meth)acrylate compound there may be mentioned "UA-13" (trade name of Shin-Nakamura Chemical Co., Ltd.).

As examples of photopolymerization initiators for component (C) there may be mentioned aromatic ketones such as benzophenone, N,N'-tetramethyl-4,4'-diaminobenzophenone (Michler's ketone), N,N'-tetraethyl-4,4'-diaminobenzophenone, 4-methoxy-4'-dimethylaminobenzophenone, 2-benzyl-2-dimethylamino-1-(4-morpholinophenyl)-butanone-1 and 2-methyl-1-[4-(methylthio)phenyl]-2-morpholino-propanone-1, quinones such as 2-ethylanthraquinone, phenanthrenequinone, 2-tert-butylanthraquinone, octamethylanthraquinone, 1,2-benzanthraquinone, 2,3-benzanthraquinone, 2-phenylanthraquinone, 2,3-diphenylanthraquinone, 1-chloroanthraquinone, 2-methylanthraquinone, 1,4-naphthoquinone, 9,10-phenanthraquinone, 2-methyl-1,4-naphthoquinone and 2,3-dimethylanthraquinone, benzoinether compounds such as benzoinmethyl ether, benzoinethyl ether and benzoinphenyl ether, benzoin compounds such as benzoin, methylbenzoin and ethylbenzoin, benzyl derivatives such as benzyldimethylketal, 2,4,5-triarylimidazole dimers such as 2-(o-chlorophenyl)-4,5-diphenylimidazole dimer, 2-(o-chlorophenyl)-4,5-di(methoxyphenyl)imidazole dimer, 2-(o-fluorophenyl)-4,5-diphenylimidazole dimer, 2-(o-methoxyphenyl)-4,5-diphenylimidazole dimer and 2-(p-methoxyphenyl)-4,5-diphenylimidazole dimer, acridine derivatives such as 9-phenylacridine and 1,7-bis(9,9'-acridinyl)heptane, and N-phenylglycine, N-phenylglycine derivative, coumarin-based compound, oxazole-based compound and the like. The aryl substituents of any two 2,4,5-triarylimidazoles may be identical for a symmetrical compound, or they may be different for an asymmetrical compound. A combination of a thioxanthone-based compound and tertiary amine compound may also be used, such as a combination of diethylthioxanthone and dimethylaminobenzoic acid. From the viewpoint of adhesiveness and sensitivity, a 2,4,5-triarylimidazole dimer is more preferred. They may be used alone or in combinations of two or more.

The content of the (A) binder polymer is preferably 30-80 parts by weight and more preferably 50-70 parts by weight with respect to 100 parts by weight as the total of component (A) and component (B). If the content is less than 30 parts by weight the photocured composition may be too brittle, tending to result in inferior coatability when it is used to form a photosensitive element, while if it is greater than 80 parts by weight the photosensitivity will tend to be insufficient.

The content of the (B) photopolymerizing compound is preferably 20-60 parts by weight and more preferably 30-55 parts by weight with respect to 100 parts by weight as the total of component (A) and component (B). If the content is less than 20 parts by weight the photosensitivity will tend to be insufficient, while if it is greater than 60 parts by weight the photocured composition may be too brittle, tending to result in inferior coatability when it is used to form a photosensitive element. From the viewpoint of tent reliability and resolution, the content of the photopolymerizing compound with an organic group represented by general formula (1) in the (B) photopolymerizing compound is preferably 1-95 wt%, more preferably 5-80 wt% and most preferably 15-50 wt%.

The content of the (C) photopolymerization initiator is preferably 0.01-20 parts by weight, more preferably 0.2-5 parts by weight and most preferably 1-4.5 parts by weight with respect to 100 parts by weight as the total of component (A) and component (B). If the content is less than 0.01 part by weight the photosensitivity will tend to be insufficient, and if it is greater than 20 parts by weight the absorption on the surface of the composition during exposure will increase, tending to result in insufficient photocuring of the interior.

The photosensitive resin composition of the invention may, if necessary, also contain additives including dyes such as malachite green, photocoloring agents such as tribromophenylsulfone, leuco crystal violet or the like, thermal development inhibitors, plasticizers such as p-toluenesulfonamide, pigments, fillers, antifoaming agents, flame retardants, stabilizers, tackifiers, leveling agents, release promoters, antioxidants, aromatics, imaging agents, thermal crosslinking agents and the like, either alone or in combinations of two or more. The content of such additives is preferably about 0.01-20 parts by weight with respect to 100 parts by weight as the total of component (A) and component (B).

The photosensitive resin composition of the invention may, if necessary, be dissolved in a solvent such as methanol, ethanol, acetone, methyl ethyl ketone, methylcellosolve, ethylcellosolve, toluene, N,N-dimethylformamide or propyleneglycol monomethyl ether, or a mixture of such solvents, for coating as a solution with a solid content of about 30-60 wt%.

The photosensitive resin composition of the invention is preferably coated as a liquid resist onto the surface of a metal such as copper, a copper-based alloy, nickel, chromium, iron or an iron-based alloy such as stainless steel, and preferably copper or a copper-based alloy or iron-based alloy, and then dried and subsequently covered with a protective film if necessary, or else used in the form of a photosensitive element.

The thickness of the photosensitive resin composition layer formed from the photosensitive resin composition of the invention will differ depending on the use, but the post-drying thickness is preferably 1-200 µm and more preferably 1-100 µm. A thickness of less than 1 µm will tend to hamper industrial coating, while a thickness of greater than 200 µm will improve the tent reliability but will also tend to result in insufficient sensitivity, thus impairing the photocuring property of the resist base.

### (Photosensitive element)

The photosensitive element of the invention comprises a support film and a photosensitive resin composition layer made of a photosensitive resin composition according to the invention formed on the support film. The photosensitive element of the invention preferably also comprises a protective film laminated in contact with the side of the photosensitive resin composition layer opposite the support film side.

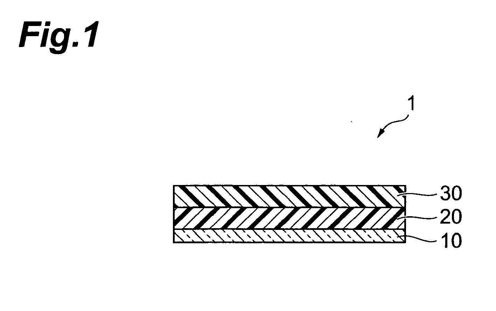

Fig. 1 is a schematic view of the cross-sectional structure of a photosensitive element according to a preferred embodiment. As shown in Fig. 1, the photosensitive element 1 comprises a support film 10, a photosensitive resin composition layer 20 formed on the support film 10 and a protective film 30 formed on the photosensitive resin composition layer 20. The photosensitive resin composition layer 20 is a layer formed using a photosensitive resin composition of the invention as described above.

As examples for the support film 10 there may be mentioned heat resistant and solvent resistant polymer films such as polyethylene terephthalate films, polypropylene films, polyethylene films and polyester films. If transparency is desired, it is preferred to use a polyethylene terephthalate film. Since such polymer films must be subsequently removable from the photosensitive resin composition layer 20, they must not be made of a material or be surface treated in a manner that would prevent their removal.

The thickness of the support film 10 is preferably 1-100 µm and more preferably 1-30 µm. If the thickness of the support film is less than 1 µm the mechanical strength will tend to be lower and the support film will be prone to tearing during coating of the photosensitive resin composition or when the support film is released before development. On the other hand, a thickness of greater than 100 µm will tend to lower the resolution and increase cost.

The photosensitive resin composition layer 20 may be formed by, for example, coating the photosensitive resin composition of the invention on the support film 10 and drying it. The coating may be accomplished by a publicly known method such as, for example, roll coating, comma coating, gravure coating, air knife coating, die coating, bar coating, spray coating or the like. The drying may be carried out at 70-150°C for about 5-30 minutes.

When the photosensitive resin composition is coated onto the support film 10, it is preferably coated as a solution of the photosensitive resin composition in a solvent such as methanol, ethanol, acetone, methyl ethyl ketone, methylcellosolve, ethylcellosolve, toluene, N,N-dimethylformamide or propyleneglycol monomethyl ether, or a mixture of such solvents, as necessary, at a solid content of about 30-60 wt%. In this case, the amount of residual organic solvent in the dried photosensitive resin composition layer 20 is preferably no greater than 2 wt% from the viewpoint of preventing diffusion of the organic solvent in subsequent steps.

The thickness of the photosensitive resin composition layer 20 will differ depending on the use, but the post-drying thickness is preferably 1-200 µm and more preferably 1-100 µm. A thickness of less than 1 µm will tend to introduce industrial difficulties for coating, while a thickness of greater than 200 µm will improve the tent reliability but will also tend to result in insufficient sensitivity, thus impairing the photocuring property of the resist base.

The protective film 30 may be a heat resistant and solvent resistant polymer film such as a polyethylene terephthalate film, polypropylene film, polyethylene film or polyester film, for example. The same type of polymer film as the support film 10 described above may be used as the protective film 30 in the photosensitive element 1.

The adhesive force between the protective film 30 and photosensitive resin composition layer 20 is preferably lower than the adhesive force between the photosensitive resin composition layer 20 and support film 10, in order to facilitate release of the protective film 30 from the photosensitive resin composition layer 20.

The protective film is preferably a low fisheye film. "Fisheyes" are contaminants, insoluble matter and oxidative degradation products that become incorporated into films during their production by heat-fusion, kneading, extrusion, biaxial stretching and casting of film materials.

The thickness of the protective film 30 is preferably 1-100 µm, more preferably 5-50 µm, even more preferably 5-30 µm and most preferably 15-30 µm. If the thickness of the protective film is less than 1 µm it will tend to be more prone to tearing during lamination, while if it is greater than 100 µm the cost of the protective film will be increased.

The photosensitive element 1 may also comprise interlayers such as a cushion layer, adhesive layer, photoabsorbing layer and gas barrier layer as necessary.

The photosensitive element 1 may be stored as is in the form of a flat sheet, or as a roll wound up on a winding core with a cylindrical or other shape. In the latter case, it is preferably wound with the support film 10 on the outermost side.

When the photosensitive element 1 has a two-layer construction with no protective film 30, the photosensitive element may be stored as is in the form of a flat sheet, or a protective film may be laminated on the side of the photosensitive resin composition layer 20 opposite the support film side and the laminate wound up as a roll on a winding core with a cylindrical or other shape.

The winding core is not particularly restricted so long as it is a conventional one, and as examples there may be mentioned plastics such as polyethylene resin, polypropylene resin, polystyrene resin, polyvinyl chloride resin, ABS resin (acrylonitrile-butadiene-styrene copolymer) and the like. From the viewpoint of edge protection, an edge separator is preferably situated at the edge of the photosensitive element that has been wound up into a roll (photosensitive element roll), and from the viewpoint of preventing edge fusion, the edge separator is preferably moisture-proof. For packaging of the photosensitive element 1, it is preferably bundled with a low moisture permeable black sheet.

### <Resist pattern forming method>

The resist pattern forming method of the invention is a method in which a photosensitive resin composition layer composed of a photosensitive resin composition of the invention, or the photosensitive resin composition layer of a photosensitive element of the invention, is laminated on a circuit-forming board, prescribed sections of the photosensitive resin composition layer are irradiated with active light rays for photocuring of the exposed sections, and the sections other than the exposed sections are then removed. A "circuit-forming board" is a board comprising an insulating layer and a conductive layer formed on the insulating layer.

When the photosensitive element 1 used in the resist pattern forming method of the invention has a protective film, a resist pattern is formed by a method comprising a lamination step in which the protective film 30 of the photosensitive element 1 is gradually released from the photosensitive resin composition layer 20 while the sections on the photosensitive resin composition layer 20 side that are gradually bared are contact bonded to the side of the circuit-forming board on which the circuit is to be formed, thus laminating the photosensitive resin composition layer 20 onto the circuit-forming board, an exposure step in which prescribed sections of the laminated photosensitive resin composition layer 20 which are to be exposed are irradiated with active light rays to form exposed sections, and a developing step in which the unexposed sections are removed leaving the exposed sections.

The method of laminating the photosensitive resin composition layer on the circuit-forming board in the lamination step may be a method in which, after removing the protective film, the photosensitive resin composition layer is heated while contact bonding the photosensitive resin composition layer to the circuit-forming board. The laminating procedure is preferably carried out under reduced pressure from the viewpoint of adhesiveness and follow-up property. For lamination of the photosensitive element, the photosensitive resin composition layer and/or circuit-forming board is preferably heated to 70-130°C and the contact bonding pressure is preferably about 0.1-1.0 MPa (about 1-10 kgf/cm²). However, there is no particular restriction to these conditions. If the photosensitive resin composition layer is heated at 70-130°C as mentioned above it is not necessary to subject the circuit-forming board to preheating beforehand. However, the circuit-forming board may still be subjected to preheating for further improved laminating properties. The surface of the circuit-forming board on which the photosensitive resin composition layer is to be laminated is not particularly restricted but will usually be a metal surface.

The method of forming the exposed sections in the exposure step may be a method of irradiation with active light rays into an image form, through a negative or positive mask pattern known as artwork (mask exposure method). When the support film on the photosensitive resin composition layer is transparent to the active light rays, the active light rays can be irradiated through the support film. When the support film is non-transparent to the active light rays, the photosensitive resin composition layer is irradiated with the active light rays after removal of the support film. A method of irradiating active light rays in an image pattern by a direct writing process using a laser exposure method may also be employed.

The light source for the active light rays may be a publicly known light source such as, for example, a carbon arc lamp, mercury vapor arc lamp, ultra-high-pressure mercury lamp, high-pressure mercury lamp, xenon lamp or the like, which efficiently emits ultraviolet rays or visible light. A light source that efficiently emits ultraviolet rays such as an Ar ion laser or semiconductor laser, or a visible light source, may also be used. A lamp that efficiently emits visible light rays may also be used, such as a photoflood lamp or sun lamp.

As a method for removing the sections other than the exposed sections in the developing step, when a support film is present on the photosensitive resin composition layer, there may be mentioned a method in which the support film is first removed and then the sections other than the exposed sections are removed by development such as wet development, dry development or the like. This procedure results in formation of a resist pattern.

In the case of wet development, a developing solution suitable for photosensitive resin compositions may be used, such as an aqueous alkali solution, aqueous developing solution or organic solvent-based developing solution, and development may be accomplished by a publicly known method such as spraying, reciprocal dipping, brushing, scrapping or the like.

The developing solution used is one which is safe and stable and easily manageable, such as an aqueous alkali solution. As bases for the aqueous alkali solution there may be used, for example, alkali hydroxides such as hydroxides of lithium, sodium, potassium and the like, alkali carbonates such as carbonates or bicarbonates of lithium, sodium, potassium, ammonium and the like, alkali metal phosphates such as potassium phosphate and sodium phosphate, and alkali metal pyrophosphates such as sodium pyrophosphate and potassium pyrophosphate.

The aqueous alkali solution used for development is preferably a 0.1-5 wt% sodium carbonate dilute solution, a 0.1-5 wt% potassium carbonate dilute solution, a 0.1-5 wt% sodium hydroxide dilute solution or a 0.1-5 wt% sodium tetraborate dilute solution. The pH of the aqueous alkali solution used for development is preferably in the range of 9-11, and the temperature is adjusted as appropriate for the developing property of the photosensitive resin composition layer. The aqueous alkali solution may also contain added surfactants, antifoaming agents, and small amounts of organic solvent to accelerate development.

An aqueous developing solution, may be a developing solution composed of water or an aqueous alkali solution and one or more different organic solvents. As bases for aqueous alkali solutions other than those already referred to above there may be mentioned borax, sodium metasilicate, tetramethylammonium hydroxide, ethanolamine, ethylenediamine, diethylenetriamine, 2-amino-2-hydroxymethyl-1,3-propanediol, 1,3-diaminopropanol-2, morpholine and the like. As examples of organic solvents there may be mentioned 3acetone alcohol, acetone, ethyl acetate, alkoxyethanols with C1-4 alkoxy groups, ethyl alcohol, isopropyl alcohol, butyl alcohol, diethyleneglycol monomethyl ether, diethyleneglycol monoethyl ether, diethyleneglycol monobutyl ether and the like. These may be used alone or in combinations of two or more.

The concentration of the organic solvent in the aqueous developing solution is preferably 2-90 wt%, and the temperature may be adjusted as appropriate for the developing property. The pH of the aqueous developing solution is preferably as low as possible in a range allowing sufficient development of the resist, and for most purposes it is preferably pH 8-12 and more preferably pH 9-10. The aqueous developing solution may also contain small amounts of added surfactants, antifoaming agents and the like.

As examples of organic solvent-based developing solutions there may be mentioned 1,1,1-trichloroethane, N-methylpyrrolidone, N,N-dimethylformamide, cyclohexanone, methyl isobutyl ketone and γ-butyrolactone. Water is preferably added to these organic solvents in a range of 1-20 wt% for anti-flammability.

Two or more different developing solutions may also be used in combination if necessary.

As examples of developing systems there may be mentioned dipping systems, paddle systems, spray systems, brushing or slapping systems. Among these, a high-pressure spray system is preferably used from the viewpoint of improved resolution.

Post-development treatment in the resist pattern forming method of the invention may consist of heating at about 60-250°C or exposure at about 0.2-10 mJ/cm² if necessary for further curing of the resist pattern.

### <Printed wiring board production process>

The process for production of a printed wiring board according to the invention comprises a step in which a circuit-forming board having a resist pattern formed by the resist pattern forming method of the invention described above is etched or plated.

The etching or plating of the circuit-forming board is carried out on the conductive layer of the circuit-forming board using the formed resist pattern as a mask. The etching solution used for etching may be, for example, a cupric chloride solution, ferric chloride solution, alkali etching solution or hydrogen peroxide-based etching solution. A ferric chloride solution is preferred among those mentioned above from the viewpoint of achieving a satisfactory etch factor. The plating process used for plating may be, for example, copper plating such as copper sulfate plating or copper pyrophosphate plating, solder plating such as high throwing solder plating, nickel plating such as Watt bath (nickel sulfate-nickel chloride) plating or nickel sulfaminate plating, or gold plating such as hard gold plating or soft gold plating.

After completion of the etching or plating, the resist pattern is released, for example, with an aqueous solution of stronger alkalinity than the aqueous alkali solution used for development. The strongly alkaline aqueous solution used here may be, for example, a 1-10 wt% sodium hydroxide aqueous solution or a 1-10 wt% potassium hydroxide aqueous solution. The releasing system may be, for example, a dipping system, spraying system or the like. These may be carried out alone or in combination.

A printed wiring board is obtained in this manner, and the printed wiring board production process of this embodiment can be applied for fabrication not only of monolayer printed wiring boards but also multilayer printed wiring boards. The production process of the invention can be suitably applied as a process for production of a multilayer printed wiring board with small through-holes.

The present invention is not in any way limited to the preferred modes described above.

### Examples

The present invention will now be explained in detail by examples, with the understanding that the invention is not limited to the examples.

### <Synthesis Example 1>

In a flask equipped with a stirrer, reflux condenser, thermometer, dropping funnel and nitrogen gas inlet tube there was added 400 g of a mixture of methylcellosolve and toluene (methylcellosolve/toluene = 3/2 (weight ratio), hereinafter referred to as "solution (s)"), and the mixture was stirred while blowing in nitrogen gas and heated to 80°C. Separately, there was prepared a solution comprising a mixture of 100 g of methacrylic acid, 250 g of methyl methacrylate, 100 g of ethyl acrylate, 50 g of styrene and 0.8 g of azobisisobutyronitrile as monomers (hereinafter referred to as "solution (a)"). Solution (a) was then added dropwise over a period of 4 hours to solution (s) that had been heated to 80°C, and the mixture was heated for 2 hours while stirring at 80°C. Also, a solution of 1.2 g of azobisisobutyronitrile in 100 g of solution (s) was added dropwise to the flask over a period of 10 minutes. After keeping the dropped solution at 80°C for 3 hours while stirring, it was heated to 90°C over a period of 30 minutes. The solution was warmed at 90°C for 2 hours, and then cooled to obtain a binder polymer solution. Acetone was added to the binder polymer solution, and the non-volatilizing component (solid portion) was adjusted to 50 wt% to obtain a binder polymer solution as component (A). The weight-average molecular weight of the obtained binder polymer was 80,000. The GPC conditions were as follows.

### (GPC conditions)

Pump: Hitachi L-6000 (trade name of Hitachi, Ltd.).
Column: Gelpack GL-R420 + Gelpack GL-R430 + Gelpack GL-R440 (total: 3) (all trade names of Hitachi Chemical Co., Ltd.)
Eluent: tetrahydrofuran
Measuring temperature: 25°C.
Flow rate: 2.05 mL/min
Detector: Hitachi L-3300 RI (trade name of Hitachi, Ltd.).

### <Synthesis Example 2>

After placing 1.0 g of sodium hydride (60% oil dispersion) in a flask equipped with a stirrer, thermometer, dropping funnel and nitrogen gas inlet tube, dry hexane was added and the mixture was washed with sodium hydride. After washing with sodium hydride, 200 g of dry tetrahydrofuran was added while blowing in nitrogen gas, and then 10.2 g of decaethyleneglycol monoacrylate was added dropwise into the flask over a period of 30 minutes and the mixture was stirred at room temperature (25°C) for 1 hour. Upon cooling the mixture to 0°C, a mixture of 200 g of dry tetrahydrofuran and 10.4 g of polyethyleneglycol #400 diacrylate (trade name: "A-400" by Shin-Nakamura Chemical Co., Ltd.) was added dropwise into the flask over a period of 60 minutes, and the mixture was stirred at 0°C for 1 hour and then at room temperature (25°C) for 2 hours. Next, 1N hydrochloric acid was added to the flask to terminate the reaction, and the organic layer and aqueous layer were separated. The organic material remaining in the aqueous layer was extracted with tetrahydrofuran and combined with the previous organic layer, and the mixture was washed with aqueous saturated sodium hydrogencarbonate and saturated saline in that order. Sodium sulfate was added to the organic layer, and the organic layer was dried, filtered and concentrated under reduced pressure to obtain component (B1).

### <Synthesis Example 3>

Component (B2) was obtained by the same procedure as Synthesis Example 2, except that 5.2 g of polyethyleneglycol #400 diacrylate was used.

### <Synthesis Example 4>

Component (B3) was obtained by the same procedure as Synthesis Example 2, except that 15.6 g of EO-modified urethane dimethacrylate (trade name: "UA-11" by Shin-Nakamura Chemical Co., Ltd.) was used instead of polyethyleneglycol #400 diacrylate.

### <Synthesis Example 5>

Component (B4) was obtained by the same procedure as Synthesis Example 2, except that 7.8 g of UA-11 (trade name of Shin-Nakamura Chemical Co., Ltd.) was used instead of polyethyleneglycol #400 diacrylate.

### (Preparation of photosensitive resin composition)

The materials listed in Table 1 were combined in the amounts also listed in the table (units: parts by weight), to prepare photosensitive resin compositions for the examples and comparative examples.

**[Table 1]**

| Component (A) | | Example 1 | Example 2 | Example 3 | Example 4 | Comp. Ex. 1 | Comp. Ex. 2 |
|---|---|---|---|---|---|---|---|
| | | 120 (Solid content: 60) | 120 (Solid content: 60) | 120 (Solid content: 60) | 120 (Solid content: 60) | 120 (Solid content: 60) | 120 (Solid content: 60) |
| Component (B) | Component (B1) | 15 | - | - | - | - | - |
| | Component (B2) | - | 15 | - | - | - | - |
| | Component (B3) | - | - | 15 | - | - | - |
| | Component (B4) | - | - | - | 15 | - | - |
| | BPE-500 ¹⁾ | 15 | 15 | 15 | 15 | 15 | 15 |
| | A-400 ²⁾ | - | - | - | - | 15 | - |
| | APG-400 ³⁾ | - | - | - | - | - | 15 |
| | FA-MECH ⁴⁾ | 10 | 10 | 10 | 10 | 10 | 10 |
| Component (C) | Component (C1) ⁵⁾ | 4 | 4 | 4 | 4 | 4 | 4 |
| | Component (C2) ⁶⁾ | 0.2 | 0.2 | 0.2 | 0.2 | 0.2 | 0.2 |
| Additive | Malachite green | 0.05 | 0.05 | 0.05 | 0.05 | 0.05 | 0.05 |
| | Leuco crystal violet | 0.5 | 0.5 | 0.5 | 0.5 | 0.5 | 0.5 |
| Solvent | Acetone | 10 | 10 | 10 | 10 | 10 | 10 |
| | Toluene | 10 | 10 | 10 | 10 | 10 | 10 |
| | Methanol | 10 | 10 | 10 | 10 | 10 | 10 |

| | | | | | | | |
|---|---|---|---|---|---|---|---|
| 1) 2,2-bis[4-(Methacryloxypentadecaethoxy)phenyl]propane (product of Shin-Nakamura Chemical Co., Ltd.) 2) Polyethyleneglycol #400 diacrylate (product of Shin-Nakamura Chemical Co., Ltd.) 3) Polypropyleneglycol #400 diacrylate (product of Shin-Nakamura Chemical Co., Ltd.) 4) γ-Chloro-β-hydroxypropyl-β'-methacryloyloxyethyl-o-phthalate (product of Hitachi Chemical Co., Ltd.) 5) 2-(o-Chlorophenyl)-4,5-diphenylimidazole dimer 6) N,N'-Tetraethyl-4,4'-diaminobenzophenone | | | | | | | |

The solution of the obtained photosensitive resin composition was then evenly coated onto a 16 µm thick polyethylene terephthalate film (PET film, trade name "G2-16" by Teijin, Ltd.), and dried for 10 minutes with a hot air convection drier at 100°C and covered with a polyethylene protective film ("NF-13", trade name of Tamapoly Co., Ltd.) to obtain a photosensitive element. The dried film thickness of the photosensitive resin composition layer was 40 µm.

### [Evaluation of tent reliability]

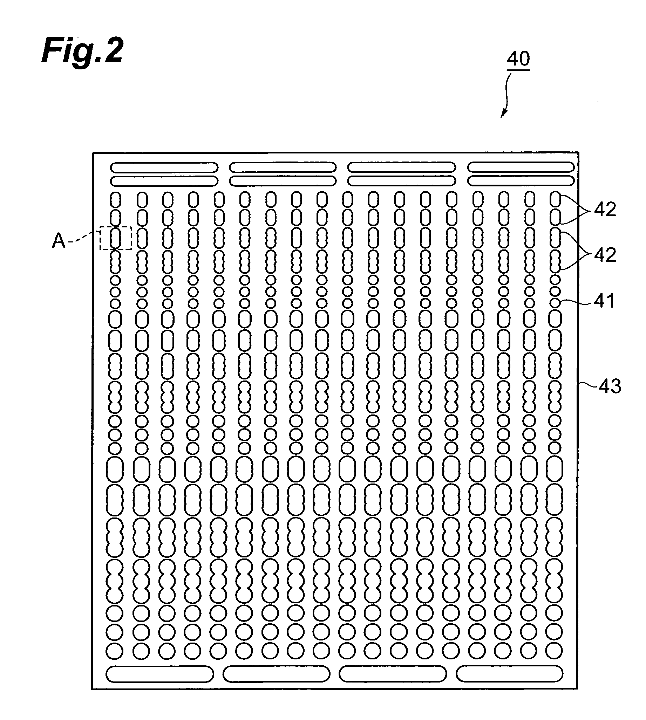

As shown in Fig. 2, a 1.6 mm-thick copper clad laminate ("MCL-E67", trade name of Hitachi Chemical Co., Ltd.) having 35 µm-thick copper foils attached on both sides was cut with a die cutter into a round hole 41 and strings of three continuous round holes 42, the hole diameters being 4 mm, 5 mm and 6 mm. The burrs produced by forming the round holes 41 and the three continuous round holes 42 were removed using a polisher (Sankei Co., Ltd.) with a #600 equivalent brush, for use as the hole tear counting board 40.

The obtained hole tear counting board 40 was heated to 80°C, and the photosensitive elements of the examples and comparative examples were each placed on the copper surface with the photosensitive resin composition layer on the hole tear counting board 40 side while releasing the protective film, and laminated under conditions of 120°C, 0.4 MPa. After lamination the hole tear counting board 40 was cooled, and when the hole tear counting board reached a temperature of 23°C, a 41-step tablet ("Hitachi 41-step tablet", trade name of Fuji Film Co.) was bonded to the PET film surface and an exposure apparatus equipped with a high-pressure mercury lamp ("HMW-201B", trade name of Orc Manufacturing Co., Ltd.) was used for photocuring of the photosensitive resin composition layer with an exposure dose for photocuring of 23 steps.

Following exposure, the board was allowed to stand at room temperature (25°C) for 15 minutes, and then the PET film support was released and developed by spraying a 1 wt% aqueous sodium carbonate solution at 30°C for 60 seconds. After development, the numbers of hole tears in the cured film (resist) that formed in the three continuous holes 42 were counted, and the irregular tent tear rate was calculated. A lower irregular tent tear rate may be considered to be more satisfactory tent reliability.

The cured film formed on the round holes 41 with hole diameters of 4 mm was pressed using cylinders with insertion diameters of 1.5 mm, and the strength and elongation until breakage were measured using a rheometer (by Rheotech Co., Ltd.). Larger numerical values for the strength and elongation measured in this manner may be considered to be more satisfactory tent reliability. The results are shown in Table 2.

### [Photosensitivity]

Each of the photosensitive elements obtained in the examples and comparative examples was used for lamination of a photosensitive resin composition layer on a copper clad laminate by the following method to obtain a laminated body. Specifically, the copper surface of a copper clad laminate ("MCL-E-67", trade name of Hitachi Chemical Co., Ltd.) comprising a glass epoxy material laminated on both sides of a copper foil (35 mm thickness) was polished using a polishing machine with a #600-equivalent brush (Sankei Co., Ltd.), and after cleaning with water, it was dried with an air stream. The obtained copper clad laminate was heated to 80°C, and the photosensitive resin composition layer was laminated on the copper clad laminate using a heat roll at 110°C at a speed of 1.5 m/min, while releasing the protective film of the photosensitive element from the photosensitive resin composition layer, to obtain a laminated body.

A Hitachi 41-step tablet was placed on the PET film of the laminated body as a negative, and an exposure apparatus (HMW-201B, trade name of Orc Manufacturing Co., Ltd.) equipped with a high-pressure mercury lamp was used for exposure of the photosensitive resin composition layer. The PET film was then released, 1 wt% aqueous sodium carbonate at 30°C was sprayed for 60 seconds to remove the unexposed sections, and the exposure dose that photocured 23 steps of the step tablet was recorded as the photosensitivity. The results are shown in Table 2. A smaller numerical value indicates higher photosensitivity.

### [Resolution]

A laminated body was fabricated under the same conditions as for evaluation of the photosensitivity described above. Next, a phototool with a Hitachi 41-step tablet and a phototool having a wiring pattern with a line width/space width of 10/10-47/47 (units: µm) as a negative for evaluation of resolution were bonded to the PET film of the laminated body. An exposure apparatus with a high-pressure mercury lamp was then used for exposure with an energy dose for 23 remaining steps after development of the Hitachi 41-step tablet. The PET film was released, and 1 wt% aqueous sodium carbonate at 30°C was sprayed for 60 seconds to remove the unexposed sections for development. The resolution was evaluated based on the smallest value for the space width between line widths that allowed clean removal of the unexposed sections by developing treatment (units: µm). The results are shown in Table 2. A smaller numerical value indicates more satisfactory resolution.

**[Table 2]**

| | Example 1 | Example 2 | Example 3 | Example 4 | Comp. Ex. 1 | Comp. Ex. 2 |
|---|---|---|---|---|---|---|
| Photosensitivity (mJ/cm²) | 62 | 65 | 64 | 67 | 62 | 75 |
| Resolution (µm) | 27 | 30 | 30 | 32 | 27 | 30 |
| Irregular tent tear rate (%) | 20 | 20 | 15 | 18 | 42 | 50 |
| Strength (N) | 5.0 | 5.1 | 5.3 | 5.3 | 4.3 | 4.0 |
| Elongation (mm) | 1.2 | 1.2 | 1.5 | 1.4 | 0.9 | 0.9 |

As seen by the results in Table 2, the photosensitive resin compositions of the invention (Examples 1-4) were demonstrated to have low irregular tent tear rates and high strength and elongation values. In contrast, the photosensitive resin compositions of Comparative Examples 1 and 2 had high irregular tent tear rates and low strength and elongation values. This confirmed that photosensitive resin compositions according to the invention can form cured films with sufficient mechanical strength and flexibility, as well as satisfactorily excellent tent reliability. The invention also provides photosensitive elements, a resist pattern forming method and a printed wiring board production process that employ the photosensitive resin compositions.

### Industrial Applicability

According to the invention it is possible to provide a photosensitive resin composition that allows formation of cured films with sufficient mechanical strength and flexibility and that has satisfactorily excellent tent reliability, as well as a photosensitive element, a resist pattern forming method and a printed wiring board production process employing the same.

## Claims

1. A photosensitive resin composition comprising (A) a binder polymer, (B) a photopolymerizing compound with an ethylenic unsaturated bond, and (C) a photopolymerization initiator,
wherein component (B) includes a photopolymerizing compound with an organic group represented by the following general formula (1). 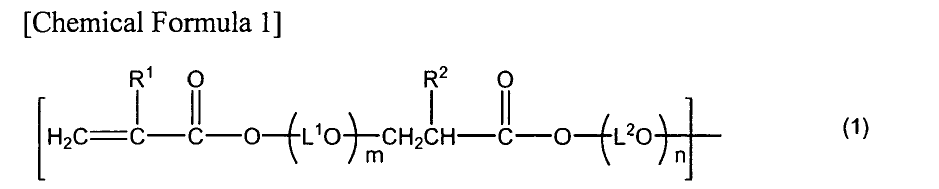 [In formula (1), R¹ and R² each independently represent hydrogen or a methyl group, L¹ and L² each independently represent a C1-6 alkylene group and m and n each independently represent an integer of 0-50 selected so that the total of m and n is 0-50.]

2. A photosensitive resin composition according to claim 1, wherein the photopolymerizing compound with an organic group represented by general formula (1) is a photopolymerizing compound represented by the following general formula (2). 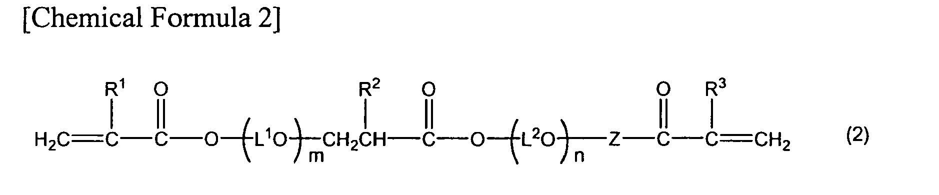 [In formula (2), R¹, R² and R³ each independently represent hydrogen or a methyl group, L¹ and L² each independently represent a C1-6 alkylene group, Z represents a single bond or a divalent organic group and m and n each independently represent an integer of 0-50 selected so that the total ofm and n is 0-50.]

3. A photosensitive resin composition according to claim 2, wherein Z is a divalent organic group represented by the following general formula (3) or (4). 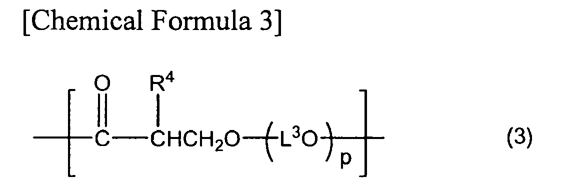 [In formula (3), R⁴ represents hydrogen or a methyl group, L³ represents a C1-6 alkylene group, and p represents an integer of 0-25.] 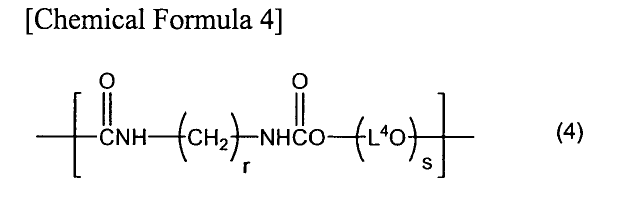 [In formula (4), L⁴ represents a C1-6 alkylene group, r represents an integer of 1-25 and s represents an integer of 0-25.]

4. A photosensitive element comprising a support film and a photosensitive resin composition layer composed of a photosensitive resin composition according to any one of claims 1 to 3 formed on the support film.

5. A resist pattern forming method wherein a photosensitive resin composition layer comprising a photosensitive element according to claim 4 is laminated on a circuit-forming board, the photosensitive resin composition layer is irradiated with active light rays in an image pattern for photocuring of the exposed sections, and the sections other than the exposed sections are removed.

6. A process for production of a printed wiring board comprising a step of etching or plating a circuit-forming board having a resist pattern formed by a resist pattern forming method according to claim 5, to form a circuit pattern.
